Europäisches Patentamt

**European Patent Office**

Office européen des brevets

(11) Publication number:

**0 322 964**

**A2**

## EUROPEAN PATENT APPLICATION

(21) Application number: 88202943.2

(22) Date of filing: 19.12.88

(51) Int. Cl.⁴ **G01R 19/165**

(30) Priority: 24.12.87 GB 8730138

(43) Date of publication of application:
05.07.89 Bulletin 89/27

(84) Designated Contracting States:
CH DE FR GB LI

(71) Applicant: **PHILIPS ELECTRONIC AND ASSOCIATED INDUSTRIES LIMITED**
**Philips House 188 Tottenham Court Road London W1P 9LE(GB)**

㉞ **GB**

Applicant: **N.V. Philips' Gloeilampenfabrieken**
**Groenewoudseweg 1**
**NL-5621 BA Eindhoven(NL)**

㉞ **CH DE FR LI**

(72) Inventor: **Knight, Paul Anthony**
**c/o PHILIPS COMPONENTS New Road**
**Mitcham Junction Mitcham Surrey CR4 4XY(GB)**

(74) Representative: **Osborne, David Ernest et al**
**PHILIPS ELECTRONICS Patents and Trade Marks Department Centre Point New Oxford Street**
**London WC1A 1QJ(GB)**

(54) Voltage level sensing circuit arrangement.

(57) A circuit for detecting when the voltage between a pair of supply conductors (1,2) rises above a first predetermined level and subsequently falls below a second predetermined level comprises a pair of emitter-coupled transistors (3,4) supplied from the conductors. The base of one transistor (3) is fed with a constant voltage relative to one supply conductor (1) by means of a Zener diode (9) and the base of the other transistor (4) is fed from the collector of the one transistor to give a hysteresis effect via a voltage divider (11,12,13). The arrangement has two states in each of which one transistor is on and the other is off, which transistors these are signifying the relevant state. The arrangement changes state when the supply voltage rises above the first predetermined level and when it subsequently falls below the second predetermined level.

## VOLTAGE LEVEL SENSING CIRCUIT ARRANGEMENT

This invention relates to a voltage level sensing circuit arrangement constructed to adopt a first state should the voltage between first and second power supply conductors therefor rise above a first predetermined level and to adopt a second state should the voltage between said supply conductors fall below a second predetermined level smaller than the first, which arrangement includes a first transistor the output electrode of which is conected to said second supply conductor via a first resistance and the common electrode of which is connected to said first supply conductor via a second resistance, and a constant voltage source connected between the control electrode of said first transistor and said first supply conductor.

Arrangements of this general kind are well known and are used, for example, to detect whether the voltage between the supply conductors is sufficient to satisfactorily drive further circuitry also supplied from these conductors. Such an arrangement known from US patent specification 3 624 617 comprises three transistors, two constant voltage sources (in the form of Zener diodes and associated series resistances) and several further resistances. It is an object of the present invention to provide an arrangement which is simpler than this known one.

To this end an arrangement as defined in the first paragraph is characterised in that the arrangement includes a second transistor which is of the same conductivity type as the first and the common electrode of which is also connected to said first supply conductor via said second resistance, the output electrode of said second transistor being connected to said second supply conductor and the control electrode of said second transistor being connected to the output electrode end of said first resistance.

It has now been recognised that a particularly simple arrangement can be obtained by providing a second transistor in such a way that the first and second transistors are coupled together via their common electrodes. Moreover, if a third resistor is included in the connection of the output electrode of the second transistor to said second supply conductor the output electrode end of this third resistor can provide a suitable take-off point for an output signal from the arrangement. Considerable flexibility can be imparted to the arrangement if the connection of the control electrode of the second transistor to the output electrode end of the first resistance is via one arm of a resistive voltage divider the other arm of which is connected between the control electrode of the second transistor and said first supply conductor, particularly if the voltage divider is variable.

(The terms "control electrode", "output electrode" and "common electrode" are to be understood herein to mean "base electrode", collector electrode" and "emitter electrode" respectively if the relevant transistor is a bipolar transistor, and to mean "gate electrode", "drain electrode" and "source electrode" respectively if the relevant transistor is a field-effect transistor.)

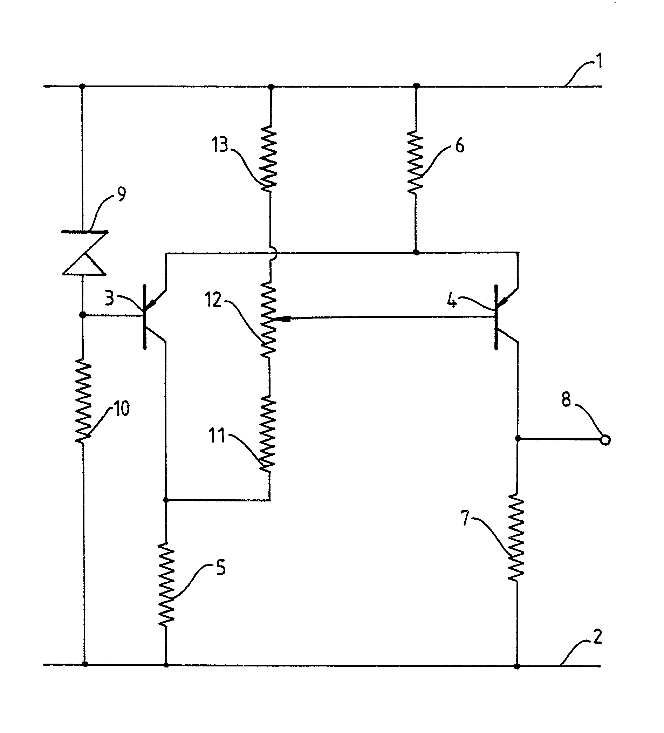

Embodiments of the invention will now be described, by way of example, with reference to the accompanying diagrammatic drawing the single Figure of which is a circuit diagram of a particular embodiment.

In the drawing a voltage level sensing circuit arrangement constructed to adopt a first state should the voltage between first and second power supply conductors 1 and 2 rise above a first predetermined level and to adopt a second state should the voltage between the conductors fall below a second predetermined level which is smaller than the first comprises first and second pnp transistors 3 and 4. The collector of transistor 3 is connected to conductor 2 via a first resistance 5 and the commoned emitters of transistors 3 and 4 are connected to conductor 1 via a second resistance 6. The collector of transistor 2 is connected to conductor 2 via a third resistance 7 and to an output terminal 8. A constant voltage source in the form of a Zener diode 9 is connected between the conductor 1 and the base of transistor 3, this base also being connected to conductor 2 via a resistance 10 to provide reverse bias for diode 9. The base of transistor 4 is connected to the tap on a (in this case variable) resistive voltage divider 11, 12, 13, one arm of which is connected to the output electrode end of resistance 5 and the other arm of which is connected to conductor 1.

In operation a positive supply voltage is applied to conductor 1 relative to conductor 2. If this voltage is increased from zero, initially transistor 3 is on and transistor 4 is off. Eventually the voltage on the tap on resistor 12 becomes sufficiently negative relative to conductor 1 to cause transistor 4 to conduct. The resulting increase in voltage across resistor 6 causes transistor 3 to turn off, this in turn increasing the voltage across divider 11, 12, 13 and assisting the turn-on of transistor 4. The action is therefore cumulative and the circuit changes from a first state in which transistor 3 is on and transistor 4 is off to a second state in which the reverse is the case. If the voltage between the conductors 1 and 2 is now reduced once again, eventually it reaches a value at which the voltage on the tap of resistor 12 is insufficiently negative to maintain transistor 4 conductive. At this point transistor 4 turns off and transistor 3 turns on once again, the action again being cumulative due to the connection of the base of transistor 4 to the collector of transistor 3 via part of the divider 11, 12 13. Moreover, due to this connection the potential difference between conductors 1 and 2 at which transistor 4 turns on is greater than the potential difference at which transistor 4 turns off, the absolute levels at which these potential differences occur being adjustable by adjusting the tap on resistor 12 and the difference between these levels being determined by the value of resistor 5 (which may be made adjustable if desired). The potential on output terminal 8 relative to conductor 2 is therefore relatively low if the voltage between conductors 1 and 2 is itself low or zero, becomes relatively high if said voltage rises above a first predetermined value, and becomes relatively low again if said voltage subsequently falls below a second predetermined value which is smaller than the first.

Of course the constant voltage source constituted by Zener diode 9 and its feed resistance 10 may be replaced by any other type of voltage source. If this is done it may be possible in some circumstances to connect the base of transistor 4 directly to the collector of transistor 3, omitting resistors 11, 12 and 13, although the resulting circuit will not be as flexible as the one described. Moreover the output signal may be taken from a point other than the collector of transistor 4, for example the collector of transistor 3 if the resulting load on this collector is sufficiently small that the operation of the circuit is not affected to an untoward extent. If this is the case resistor 7 can be replaced by a direct connection. Obviously the pnp transistors shown can be replaced by npn transistors if the sign of the voltage between conductors 1 and 2, and the polarity of diode 9, are reversed. Furthermore the pnp bipolar transistors shown may be replaced by p-channel (or n-channel if the sign of the voltage between conductors 1 and 2 is reversed) field-effect transistors the sources, drains and gates of which then replace the emitters, collectors and bases respectively of the bipolar transistors shown.

In a practical example of the circuit shown in the drawing resistors 5, 6, 7, 10, 11, 12 and 13 had values of 1.2K ohms, 8.2K ohms, 1K ohm, 2.4K ohms, 47K ohms, 20K ohms and 82K ohms respectively, and Zener diode 9 was a 5.1 volt type. As the voltage between conductors 1 and 2 was increased from zero the arrangement changed state at 7.8 volts. When this voltage was subsequently decreased once again the arrangement changed back to its first state at 7.5 volts.

From reading the present disclosure, other modifications will be apparent to persons skilled in the art. Such modifications may involve other features which are already known in the design, manufacture and use of circuit arrangements and component parts thereof and which may be used instead of or in addition to features already described herein. Although claims have been formulated in this application to particular combinations of features, it should be understood that the scope of the disclosure of the present application also includes any novel feature or any novel combination of features disclosed herein either explicitly or implicitly or any generalisation thereof, whether or not it relates to the same invention as presently claimed in any claim and whether or not it mitigates any or all of the same technical problems as does the present invention. The applicants hereby give notice that new claims may be formulated to such features and or combinations of such features during the prosecution of the present application or of any further application derived therefrom.

## Claims

1. A voltage level sensing circuit arrangement constructed to adopt a first state should the voltage between first and second power supply conductors therefor rise above a first predetermined level and to adopt a second state should the voltage between said supply conductors fall below a second predetermined level smaller than the first, which arrangement includes a first transistor the output electrode of which is connected to said second supply conductor via a first resistance and the common electrode of which is connected to said first supply conductor via a second resistance, and a constant voltage source connected between the control electrode of said first transistor and said first supply conductor, characterised in that the arrangement includes a second transistor which is of the same conductivity type as the first and the common electrode of which is also connected to said first supply conductor via said second resistance, the output electrode of said second transistor being connected to said second supply conductor and the control electrode of said second transistor being connected to the output electrode end of said first resistance.

2. An arrangement as claimed in Claim 1, wherein the connection of the control electrode of the second transistor to the output electrode end of the first resistance is via one arm of a resistive voltage divider the other arm of which is connected between the control electrode of the second transistor and said first supply conductor.

3. An arrangement as claimed in Claim 2, wherein the voltage divider is variable.

4. An arrangement as claimed in any preceding Claim. wherein a third resistor is included in the connection of the output electrode of the second transistor to the second supply conductor.